# FASCICULE DE BREVET EUROPEEN

(11) **EP 0 581 625 B1**
(45) Date de publication et mention de la délivrance du brevet: **06.06.2001**
(21) Numéro de dépôt: 93401674.2
(22) Date de dépôt: 29.06.1993
(51) Int. Cl.: H01L 27/07, H01L 27/12

(54) **Composant életronique multifonctions, notamment élément à résistance dynamique négative, et procédé de fabrication correspondant**
Multifunktionale elektronische Vorrichtung, insbesondere Element mit dynamischem, negativem Widerstandsverhalten und Zugehöriges Herstellungsverfahren
Multifunctional electronic device, in particular element with a negative dynamic resistance and corresponding method of fabrication

(30) Priorité: 09.07.1992 FR 9208502
(43) Date de publication de la demande: 02.02.1994
(73) Titulaire: FRANCE TELECOM, 75015 Paris (FR)
(72) Inventeur: Skotnicki, Tomasz, F-38240 Meylan (FR); Merckel, Gérard, F-38330 Montbonnot (FR)
(74) Mandataire: Casalonga, Axel

(56) Documents cités:
- WO-A-90/15442
- FR-A- 2 227 644
- US-A- 4 922 315
- IEEE TRANSACTIONS ON ELECTRON DEVICES vol. 27, no. 2 , Février 1980 , NEW YORK US pages 414 - 419 CHING-YUAN WU ET CHUNG-YU WU 'An Analysis and the Fabrication Technology of the Lambda Bipolar Transistor'
- IBM TECHNICAL DISCLOSURE BULLETIN. vol. 17, no. 4 , Septembre 1974 , NEW YORK US page 1041 H.M. DALAL ET R.L. VERKUIL 'Gate controlled bistable bipolar transistor'

## Description

L'invention concerne les structures semi-conductrices multi-fonctions, capables en particulier de fonction transistor, bipolaire et/ou à effet de champ, et/ou capables de présenter une résistance dynamique négative.

On connaît des technologies existantes permettant de réaliser des transistors à effet de champ et bipolaire topologiquement séparés sur un substrat semi-conducteur. On peut citer par exemple la technologie dite BiCMOS, qui groupe sur la même pastille de silicium des transistors à grille isolée à canal N et P (transistor CMOS), associés par exemple à un transistor bipolaire NPN. Ces transistors sont topologiquement séparés, car disposés côte à côte et complètement isolés les uns des autres.

On connaît également, notamment par le brevet britanique n° 1 397 789, des composants électroniques capables de présenter une résistance dynamique négative, c'est-à-dire une configuration courant-tension dans laquelle le courant décroît lorsque la tension augmente. Cependant, de tels composants sont réalisés à partir d'éléments discrets et n'offrent par conséquent pas de structure intégrée.

Le brevet US n° 4 032 961 décrit une structure intégrée capable de présenter une résistance dynamique négative, qui incorpore un transistor bipolaire contrôlé par un transistor à effet de champ à jonction (transistor JFET). Par ailleurs, dans une telle structure, le contact d'émetteur se situe sur le substrat, ce qui la rend incompatible avec une technologie de fabrication CMOS/BiCMOS, car dans ce cas, le substrat servirait d'émetteur commun pour tous les transistors fabriqués simultanément, et ceux-ci ne seraient alors plus isolés les uns des autres.

Le document WO 90/15442, A décrit une structure intégrée, qui comporte un transistor bipolaire et un transistor MOS.

On ne connaît pas actuellement de structure intégrée capable de réaliser une fonction de transistor à effet de champ à grille isolée, ou une fonction de transistor bipolaire, éventuellement contrôlé par le précédent, et/ou de présenter une résistance dynamique négative.

L'invention vise à remédier à cette lacune.

Un but de l'invention est de proposer un tel composant présentant une structure intégrée très compacte, nécessitant un nombre réduit de masques nécessaires à sa fabrication.

L'invention a encore pour but de former un tel composant qui soit compatible avec des technologies de fabrication du type BiCMOS.

Telle que revendiquée l'invention propose un composant électronique comprenant, intégrées au sein d'une seule et même structure semi-conductrice une première zone semi-conductrice, formant les régions de drain, de source et de grille d'un transistor à effet de champ à grille isolée à canal P ou N, et une deuxième zone semi-conductrice formant les régions d'émetteur, de base et de collecteur d'un transistor bipolaire latéral du type NPN si le transistor à effet de champ est à canal P et du type PNP si le transistor à effet de champ est à canal N, les deux zones possédant une couche semi-conductrice commune du même type de conductivité que celle de la région de base, incluant la région de canal du transistor à effet de champ et/ou une région de circulation du courant de base du transistor bipolaire, les deux zones formant ensemble une structure capable de résistance dynamique négative obtenue au niveau du collecteur par déplétion de la région de canal.

Selon un mode de réalisation de l'invention, la structure semi-conductrice comporte un bloc semi-conducteur supportant la grille saillante isolée du transistor à effet de champ; la couche semi-conductrice commune s'étend dans la partie supérieure du bloc sous la grille, tandis que le reste de la première zone, susceptible de former le transistor à effet de champ, s'étend de part et d'autre de ladite couche commune, et que la deuxième zone, susceptible de former le transistor bipolaire latéral, se situe partiellement dans la partie inférieure du bloc, décalée latéralement par rapport à la première zone.

Ce composant comporte avantageusement un collecteur intrinsèque s'étendant dans la région inférieure du bloc jusqu'à une distance prédéterminée de la région d'émetteur du transistor bipolaire, en définissant ainsi l'épaisseur de la base intrinsèque du transistor bipolaire, qui peut être submicronique.

Ce composant comprend de préférence un contact commun pour la base extrinsèque du transistor bipolaire et le drain du transistor à effet de champ, ainsi que des contacts distincts pour l'émetteur et le collecteur extrinsèque du transistor bipolaire et la source du transistor à effet de champ.

Selon un mode de réalisation de l'invention, la structure semi-conductrice comporte :
- un substrat semi-conducteur ayant un premier type de conductivité, par exemple le type P,
- une couche isolante située sur une partie d'une première face du substrat, et supportant une première région semi-conductrice saillante, formant la région de grille du transistor à effet de champ, et ayant le premier type de conductivité, par exemple le type P⁺,
- une première paire de régions semi-conductrices, localisées au sein du substrat, de part et d'autre d'une première zone d'extrémité de la région saillante, formant respectivement d'une part, la région de source et, d'autre part, la région de drain ou celle de base extrinsèque, et ayant le premier type de conductivité, par exemple le type P⁺,
- une deuxième paire de régions semi-conductrices, localisées au sein du substrat, de part et d'autre d'une deuxième zone d'extrémité de la région saillante, opposée à la première zone d'extrémité, formant respectivement la région d'émetteur et celle de collecteur extrinsèque, et ayant un deuxième type de conductivité opposé au premier, par exemple le type N⁺,
- une couche enterrée semi-conductrice, ayant le deuxième type de conductivité, par exemple le type N, et s'étendant à distance de la première face du substrat en étant en contact avec la région de la deuxième paire formant le collecteur extrinsèque, et à distance de l'autre région de cette deuxième paire, susceptible de former l'émetteur,
- une première métallisation disposée au contact de la région de la première paire formant le drain ou la base extrinsèque, et
- au moins deux autres métallisations disposées respectivement au contact des deux régions de la deuxième paire ou au contact, d'une part, de la région formant la source et, d'autre part, de la région saillante susceptible de former la grille.

La région saillante et les quatre régions des deux paires sont avantageusement surdopées, et les quatre régions des deux paires s'étendent de préférence depuis la première face du substrat jusqu'à la face opposée.

Afin de minimiser les fuites de courant à travers le reste du substrat, il est particulièrement avantageux que le substrat de la structure semi-conductrice soit un substrat sur isolant.

Un tel composant peut être utilisé en tant que transistor à effet de champ; dans ce cas, il comporte au moins trois contacts métalliques sur les régions de grille, source et drain.

Dans une telle utilisation, il est particulièrement avantageux d'appliquer une tension de polarisation choisie sur la région de collecteur, munie dans ce cas d'un contact métallique; cette tension de polarisation choisie sera positive dans le cas d'un transistor à effet de champ à canal P et négative dans le cas d'un transistor à effet de champ à canal N.

Un tel composant peut également être utilisé en tant que transistor bipolaire; dans ce cas, il comporte au moins trois contacts métalliques sur les régions de base, collecteur et émetteur.

Dans une telle utilisation, il est particulièrement avantageux d'appliquer une tension de polarisation choisie sur la grille, munie également d'un contact métallique; cette tension de polarisation choisie sera négative dans le cas d'un transistor à effet de champ à canal P et positive dans le cas d'un transistor à effet de champ à canal N.

Le composant selon l'invention peut également présenter une configuration de résistance dynamique négative; dans ce cas, il comporte des contacts métalliques sur les régions de grille, drain-base, collecteur et émetteur.

On peut, dans une telle utilisation, alors que la jonction émetteur-base du transistor bipolaire est polarisée en direct, polariser la jonction collecteur-base en inverse tout en appliquant une polarisation choisie sur la grille pour dépléter au moins partiellement le canal du transistor à effet de champ.

La résistance dynamique négative peut être obtenue à partir de la relation courant-tension collecteur.

Telle que revendiquée, l'invention a également pour objet un procédé de fabrication d'une structure semi-conductrice intégrant un transistor à effet de champ à grille isolée et un transistor bipolaire latéral, dans lequel :
a) on réalise, sur une première face d'un substrat semi-conducteur ayant un premier type de conductivité (par exemple le type P), une région saillante isolée, formant la région de grille du transistor à effet de champ et ayant également le premier type de conductivité, et, dans la partie inférieure du substrat, une couche enterrée ayant un deuxième type de conductivité, opposé au premier, et s'étendant dans une portion de la partie inférieure du substrat, au moins sous la région saillante,
b) on implante dans le substrat, une première paire de régions semi-conductrices, localisées de part et d'autre d'une première zone d'extrémité de la région saillante, formant respectivement, d'une part, la région de source et, d'autre part, la région de drain ou celle de base extrinsèque, ces deux régions semi-conductrices de cette première paire ayant également le premier type de conductivité (par exemple le type P⁺),
c) on implante dans le substrat une deuxième paire de régions semi-conductrices ayant le deuxième type de conductivité, localisées de part et d'autre d'une deuxième zone d'extrémité de la région saillante, opposée à la première; l'une de ces régions, située à l'extérieur de la couche enterrée, forme la région d'émetteur, l'autre région, située au contact de cette couche enterrée, formant la région de collecteur extrinsèque, et
d) on métallise la région de la première paire formant drain ou base extrinsèque, et au moins les deux régions de la deuxième paire ou, d'une part, la région formant la source et, d'autre part, la région saillante formant la grille.

Les étapes d'implantation des quatre régions des deux paires comportent avantageusement des surdopages, éventuellement graduels.

Selon un mode de mise en oeuvre de l'invention, dans l'étape a) :
a1) on implante au sein du substrat une région enterrée, s'étendant à distance de la première face du substrat et ayant le deuxième type de conductivité, par exemple le type N,
a2) on forme sur le substrat ainsi implanté, un empilement contenant une couche isolante surmontée d'une couche semi-conductrice ayant le premier type de conductivité, par exemple le type P, elle-même surmontée d'une couche supérieure (par exemple de nitrure de silicium) apte à former un masque d'implantation,
a3) on retire au moins une portion de cet empilement pour mettre à nu la portion correspondante de la première face du substrat et pour définir au moins un premier flanc ou borne de la région saillante,
a4) on effectue une implantation choisie de dopants de la structure ainsi obtenue pour délimiter ladite région enterrée et former ladite couche enterrée.

Selon une variante de l'invention, on effectue ladite implantation choisie de la région enterrée, sensiblement perpendiculairement à la première face du substrat.

Dans ce cas, postérieurement à l'étape a4), on retire avantageusement une autre portion de l'empilement, pour mettre à nu la portion correspondante de la première face du substrat et pour définir le deuxième flanc ou borne de la région saillante, ce deuxième flanc étant opposé au premier; on dispose des régions latérales isolantes, ou espaceurs, au contact des deux flancs de la région saillante de grille, ces espaceurs ayant une largeur prédéterminée au niveau de la première face du substrat, et, dans l'étape c), on implante les deux régions de la deuxième paire de part et d'autre des régions latérales isolantes ou espaceurs.

Dans l'étape b), on peut effectuer, dans une première zone d'implantation située de pan et d'autre des espaceurs, et au voisinage de ladite première zone d'extrémité de la région saillante, une première implantation choisie de dopants pour surdoper (par exemple P⁺) ladite première zone d'implantation par rapport au substrat, puis on retire les espaceurs et on effectue, dans une deuxième zone d'implantation prolongeant la première jusqu'aux deux bornes de la région saillante, une deuxième implantation de même type que la première, ce qui permet d'obtenir les deux régions de la première paire avec un dopage non uniforme (P⁺⁺, P⁺).

Selon une autre variante de l'invention, on retire, dans l'étape a3), une autre portion de l'empilement pour, d'une part, mettre à nu la portion correspondante de la première face du substrat et définir le deuxième flanc, ou borne de la région saillante, opposé au premier, et, d'autre part, faire déborder de la face supérieure de cette région saillante ladite couche de masque d'une distance prédéterminée, puis l'on effectue l'implantation choisie de l'étape a4), pour délimiter la couche enterrée, selon une direction oblique, par rapport à la première face du substrat.

On implante alors avantageusement les deux régions de la deuxième paire, susceptibles de former l'émetteur et le collecteur, en effectuant une implantation choisie de dopant sensiblement verticalement sur la structure munie du masque débordant fixé sur la grille.

On réalise également avantageusement l'implantation des deux régions de la première paire, susceptibles de former le drain et la source, en effectuant une première implantation choisie de dopant sensiblement verticalement sur la structure munie du masque débordant fixé sur la grille, puis, après avoir retiré ce masque, on effectue une deuxième implantation choisie de dopant pour obtenir des régions ayant un dopage non uniforme (P⁺, P⁺⁺).

D'autres avantages et caractéristiques de l'invention apparaîtront à l'examen de la description détaillée ci-après et des dessins annexés, sur lesquels :
la figure 1 est une vue de dessus schématique d'une structure intégrée selon l'invention,
la figure 2 est la coupe schématique selon la ligne II-II de la figure 1,
la figure 3 est la coupe schématique selon la ligne III-III de la figure 1,
les figures 4a à 4g illustrent un premier mode de mise en oeuvre du procédé de fabrication selon l'invention, permettant d'obtenir la structure illustrée sur les figures 1 à 3,
les figures 5a à 5h illustrent un deuxième mode de mise en oeuvre du procédé de fabrication selon l'invention, permettant d'obtenir la structure semi-conductrice illustrée sur la figure 5i,
la figure 6 illustre de façon simplifiée une utilisation du composant selon l'invention en tant que transistor à effet de champ,
la figure 7 illustre de façon simplifiée une utilisation du composant selon l'invention en tant que transistor bipolaire, et
les figures 8 et 9 illustrent de façon simplifiée une utilisation du composant selon l'invention, capable de présenter une résistance dynamique négative.

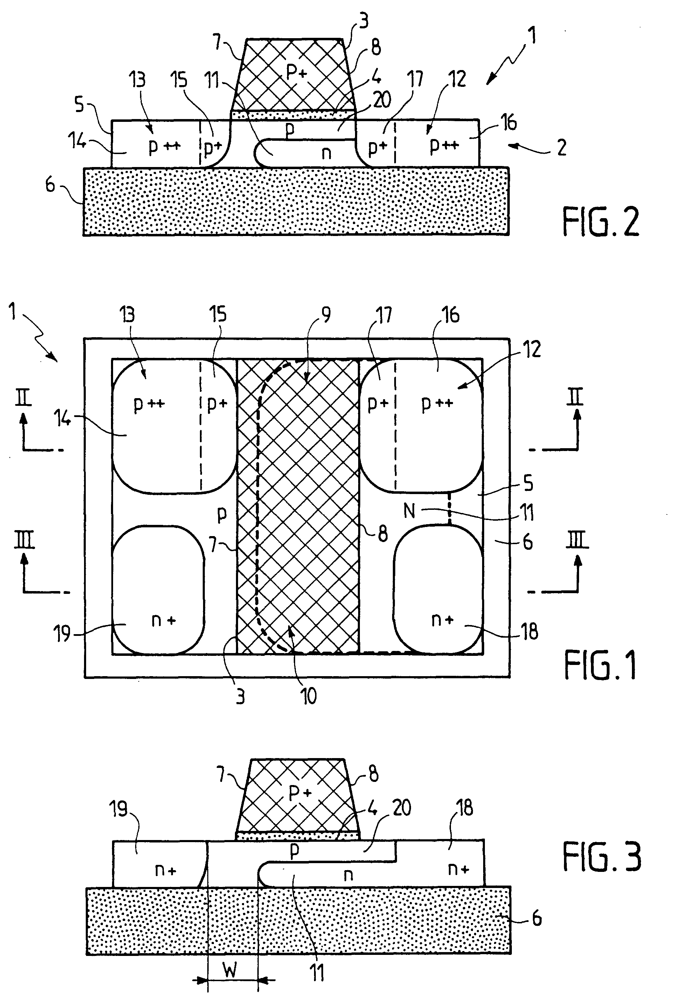

Sur la figure 1, la référence 1 désigne une structure semi-conductrice, comportant un bloc semi-conducteur 2 se composant d'un substrat 5 reposant sur un isolant 6. L'homme du métier comprendra donc immédiatement que la structure semi-conductrice est réalisée ici à partir d'un substrat sur isolant, communément désigné sous le vocable anglais SOI (silicon on insulator).

Un tel substrat sur isolant minimise notamment les fuites locales de courant à travers le reste du substrat. Néanmoins, il est possible d'utiliser un substrat massif de type P (par exemple), voire un substrat massif de type N dans lequel a été réalisé un caisson de type P.

Le substrat 5, réalisé à base de silicium, a une largeur de l'ordre de 5 µm, une longueur de l'ordre de 5 µm, et une épaisseur de l'ordre de 200nm de (2000 Ångströms).

La première face, ou face supérieure, du substrat 5 du bloc semi-conducteur 2, supporte une couche isolante 4, par exemple en dioxyde de silicium, surmontée d'une région saillante 3 réalisée en silicium polycristallin surdopé P⁺, ayant le type de conductivité P (conduction par trous). Cette région saillante 3 comporte deux flancs latéraux, ou bornes, 7 et 8, et les références 9 et 10 désignent respectivement des première et deuxième zones d'extrémité de cette région saillante 3.

Dans la partie inférieure du substrat 5, composé de silicium de type P, se situe une couche enterrée 11 ayant le type de conductivité opposé, c'est-à-dire le type N (conduction par électrons). Cette couche enterrée 11, qui se situe à distance de la face supérieure du substrat, s'étend dans une portion seulement de la partie inférieure du substrat 5, à savoir sous la région saillante 3 en débordant celle-ci en direction de son flanc droit 8.

De part et d'autre de la première zone d'extrémité 9 de la région saillante 3, se situent deux régions implantées 12 et 13, ayant le type de conductivité P. Ces deux régions sont surdopées avec un surdopage non uniforme. Plus précisément, la partie 17 de la région 12, située la plus proche de la région saillante 3, présente un surdopage de type P⁺, c'est-à-dire une concentration de trous de l'ordre de 10¹⁸ cm⁻³, alors que la partie 16 de cette région 12, la plus éloignée de la région saillante 3, présente un surdopage de type P⁺⁺, c'est-à-dire une concentration en trous de l'ordre de 10²⁰ cm⁻³. On rappele ici qu'un dopage de type P correspond à une concentration en trous de l'ordre de 10¹⁶ cm⁻³.

De façon symétrique, la région 13 comporte une partie 15 dopée P⁺ et une partie 14 dopée P⁺⁺.

Ces deux régions, formant une première paire, s'étendent depuis la face supérieure du substrat jusqu'à sensiblement la face inférieure. Dans ce mode de réalisation, la région 13 n'est pas en contact de la couche enterrée 11, alors que la région 12 l'est.

De part et d'autre de la deuxième zone d'extrémité 10 de la région saillante 3, sont situées deux régions implantées 18 et 19 formant une deuxième paire. Ces deux régions ont le type de conductivité N et sont avantageusement surdopées N⁺. Elles s'étendent toutes deux depuis la face supérieure du substrat jusqu'à sensiblement sa face opposée. La région 19, située du côté de la borne gauche 7 n'est pas en contact avec la couche enterrée 11, et s'en situe à une distance prédéterminée w, dont on reviendra plus en détail ci-après sur la signification, et qui est avantageusement submicronique, typiquement de l'ordre de 0,1 µm. L'autre région 18 de cette deuxième paire, située du côté de la borne droite 8 de la région saillante, vient par contre au contact de la couche enterrée 11.

Une telle structuré est munie de métallisations qui vont permettre d'en définir les fonctions.

Dans l'exemple de réalisation préférentiel décrit ici, la structure semi-conductrice comporte cinq métallisations (non représentées ici à des fins de simplification), bien qu'il soit possible, comme on le verra ci-après, de n'en disposer que de trois.

Plus précisément, chacune des deux régions 12 et 13 de la première paire et 18 et 19 de la deuxième paire, comporte une métallisation. Une cinquième métallisation est également prévue sur la région saillante 3. A cet effet, compte tenu du fait que la largeur de cette région peut être inférieure à 1 µm, il est préférable de prévoir une extension latérale (non représentée à des fins de simplification) de cette région, prolongeant par exemple la zone d'extrémité 9, plus large et sur laquelle est disposée cette cinquième métallisation.

La structure semi-conductrice ainsi décrite, comporte deux zones semi-conductrices. L'une de ces zones est susceptible de former un transistor à effet de champ à grille isolée. Plus précisément, la région 12 constitue le drain de ce transistor, tandis que la région 13 en constitue la source. La région saillante 3 forme la région de grille de ce transistor. Le canal du transistor à effet de champ est susceptible de se former dans la couche 20 du substrat 5 situé en partie au-dessus de la couche enterrée N, dans la partie supérieure du bloc semi-conducteur 2, sous la grille 3.

La deuxième zone semi-conductrice est susceptible de former un transistor bipolaire latéral. Plus précisément, la région 12 en constitue la base extrinsèque, tandis que la région 19 en constitue l'émetteur et que la région 18 en constitue le collecteur extrinsèque. La couche enterrée 11 forme le collecteur intrinsèque et la distance w séparant l'extrémité de cette couche enterrée 11 de la région d'émetteur 19, définit l'épaisseur de la base intrinsèque du transistor bipolaire. L'homme du métier remarquera ici que le courant de base de ce transistor bipolaire sera susceptible de circuler également dans la couche supérieure 20. Cette couche supérieure est donc commune aux deux zones semi-conductrices.

Par ailleurs, comme on le verra en détail ci-après, ces deux zones forment, en combinaison, une structure semi-conductrice capable de résistance dynamique négative.

On a décrit ici un transistor à effet de champ à grille isolée à canal P associé à un transistor bipolaire latéral de type NPN. Bien entendu, en inversant tous les types de dopants, il serait possible d'associer au sein de la même structure, un transistor à effet de champ à grille isolée à canal N avec un transistor bipolaire latéral du type PNP.

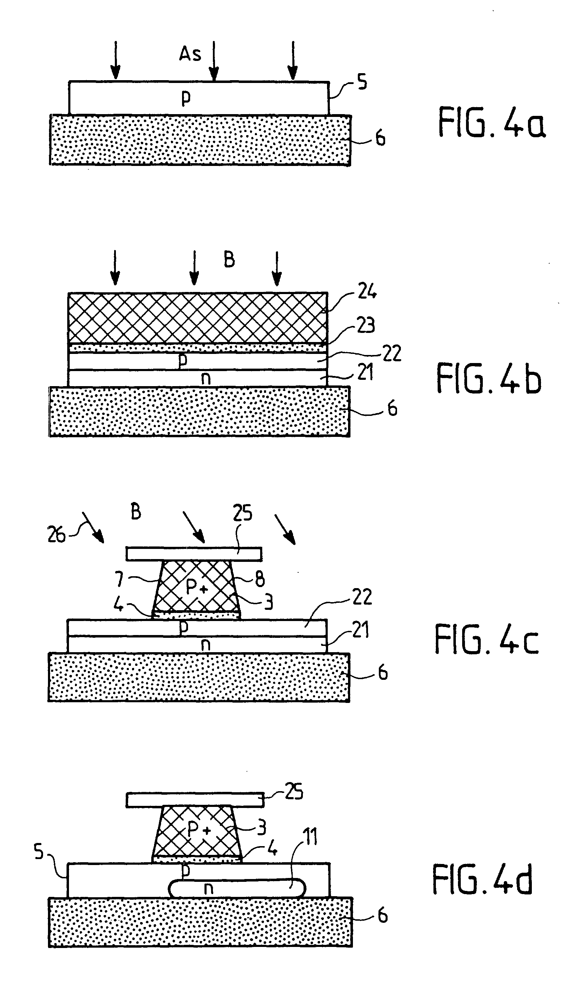

On va maintenant décrire en détail, en se référant plus particulièrement aux figures 4a à 4g, une première variante d'un procédé de fabrication permettant d'obtenir le composant électronique illustré sur les figures 1 à 3.

Le produit de départ, illustré sur la figure 4a, est un substrat sur isolant, composé d'un film 5 de silicium de type P sur du dioxyde de silicium 6. Une première étape consiste en une implantation profonde de dopants (Arsenic ou phosphore) de façon à former dans la partie inférieure du film 5 une région enterrée 21 de type N.

On dépose ensuite sur la face supérieure de la partie supérieure 22 du substrat, de type P, une couche de dioxyde de silicium 23 destinée à former l'oxyde de grille. On dépose ensuite sur cette couche 23 une couche supérieure 24 de silicium polycristallin que l'on implante (bore) de façon à lui conférer un surdopage de type P⁺.

On dépose ensuite sur la couche de silicium polycristallin 24 une couche:, par exemple de nitrure de silicium, destinée à former un masque pour une implantation ultérieure. On définit ensuite les dimensions de cette table de nitrure 25 et l'on effectue une attaque isotropique du silicium polycristallin 24, de façon à définir les bornes gauche et droite 7 et 8 de la grille 3. La table de nitrure déborde des bornes de la grille d'une distance choisie qui est déterminante pour la définition de l'épaisseur de la base du futur transistor bipolaire.

On effectue ensuite, sur la structure ainsi obtenue, et illustrée sur la figure 4c), une implantation oblique de bore à haute énergie 26, de façon à délimiter la région enterrée 21 et définir ainsi la couche enterrée 11 de type N (figure 4d). L'implantation oblique s'effectue ici selon un angle de l'ordre de 45° à 60° par rapport à la verticale. La table de nitrure a empêché l'implantation de dopants au sein de la grille 3.

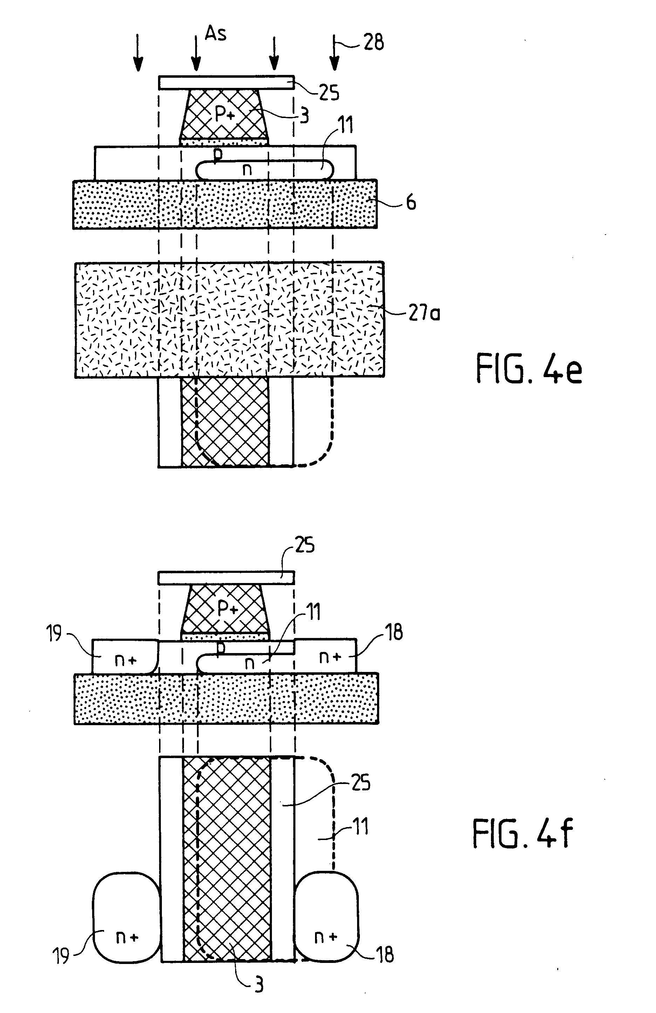

L'étape suivante, illustrée sur la figure 4e, consiste à déposer un masque 27a sur la structure obtenue à la figure 4d, dans la région de la première zone d'extrémité de la grille 3. On effectue alors une implantation d'Arsenic ou de phosphore à haute énergie 28, de façon à former les deux régions 18 et 19 de la deuxième paire, illustrées sur la figure 4f. Le masque 27a a pour fonction d'éviter une implantation de dopants de part et d'autre de la première zone d'extrémité de la grille, et l'utilisation de la table de nitrure permet d'effectuer une implantation des régions 18 et 19 autopositionnée par rapport à la grille 3. Par ailleurs, on remarque ici que, en raison du débordement de la table de nitrure 25 de part et d'autre de la grille 3, la région 19 se situe à distance de la couche enterrée 11, ce qui matérialise l'épaisseur w de la base intrinsèque du transistor bipolaire.

Sur la figure 4g, le masque 27a a été gravé et un masque 27b a été placé cette fois-ci au niveau de la deuxième zone d'extrémité de la grille 3, au-dessus des régions 18 et 19, de façon à pouvoir effectuer une première implantation de bore à forte dose 29, pour réaliser les deux régions 12 et 13 de la figure 1. On grave ensuite les régions débordantes de la table de nitrure, de façon à effectuer une deuxième implantation de bore pour obtenir un dopage non uniforme des régions 12 et 13, telles qu'illustrées sur la figure 1. Ce dopage non uniforme est connu de l'homme du métier sous le vocable LDD (Lighty doped drain).

Le masque de nitrure est ensuite gravé, au même titre que le masque 27b, et l'on effectue des métallisations sur les régions souhaitées, par dépôt d'une couche de métal (par exemple du titane) pour former un siliciure sur les zones de silicium semi-conductrices (TiSi₂).

L'effet d'ombre, intervenant lors d'une implantation oblique, est en général considéré par l'homme du métier comme un effet parasite qui provoque, par exemple, les caractéristiques asymétriques du transistor à grille isolée, un non recouvrement du canal par la grille et un vieillissement accéléré des structures. Cependant, selon l'invention, l'emploi de cet effet d'ombre permet de réaliser un composant électronique qui présente à la fois les fonctions combinées d'un transistor à effet de champ à grille isolée, bipolaire, et susceptible de présenter une résistance dynamique négative, tout en utilisant un nombre réduit de masques nécessaires pour la fabrication. L'implantation oblique permet ainsi directement de délimiter la couche enterrée de collecteur intrinsèque et, en combinaison avec la table de nitrure, de définir précisément la largeur de la base qui peut être ainsi réduite très fortement.

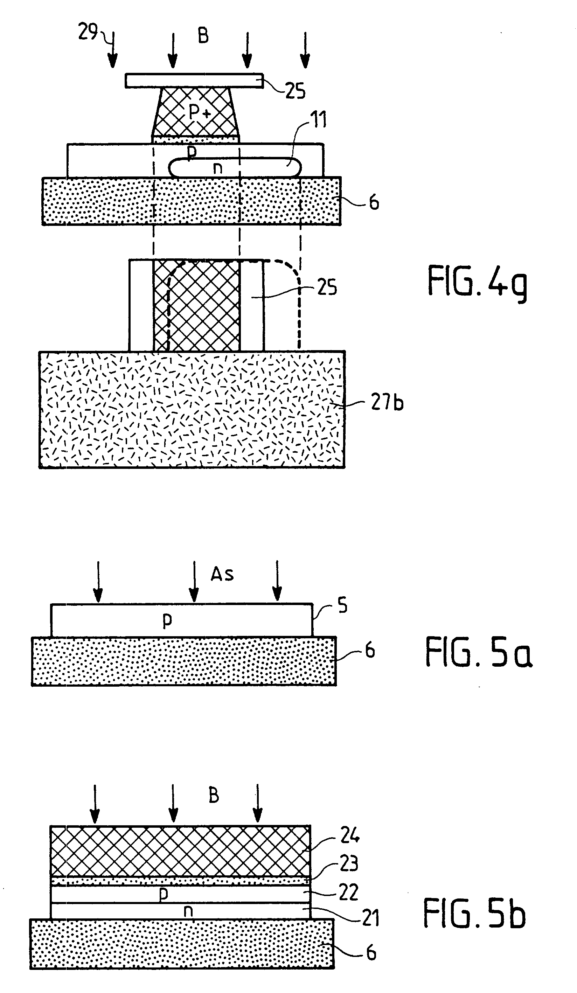

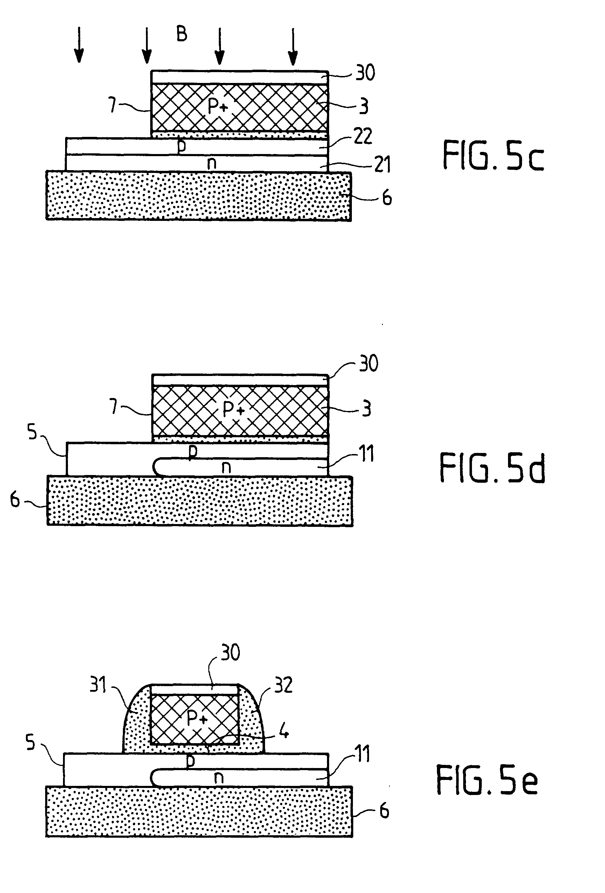

Les figures 5a à 5h illustrent une autre variante du procédé de fabrication selon l'invention que l'on va maintenant décrire en détail.

Les premières étapes de cette variante, illustrées sur les figures Sa et 5b sont identiques à celles qui ont été décrites en relation avec les figures 4a et 4b et ne seront pas reprises ici.

Si l'on se réfère maintenant plus particulièrement à la figure 5c, après avoir déposé sur le silicium polycristallin dopé P⁺ une couche de nitrure 30, on définit, à l'aide d'un masque, la borne gauche de la grille et l'on effectue une attaque anisotropique du nitrure et du silicium polycristallin de façon à former effectivement le flanc ou borne gauche de la grille 3.

On effectue ensuite une implantation de bore à haute énergie, sensiblement verticalement, c'est-à-dire sensiblement perpendiculairement à la face supérieure du substrat, de façon à délimiter la région inférieure enterrée 21, de type N, pour délimiter la couche enterrée 11 (figure 5d).

On définit ensuite, par analogie avec la borne gauche, la borne droite de la grille et l'on effectue une attaque anisotropique du nitrure et du silicium polycristallin de façon à former effectivement le flanc droit de cette grille. Puis on effectue un dépôt de dioxyde de silicium suivi d'une attaque anisotropique, de façon à former des régions latérales isolantes, ou espaceurs, 31 et 32, sur les flancs de la grille. Ces espaceurs ont, au niveau de la face supériure du substrat, une épaisseur prédéterminée qui sera déterminante pour la définition de la largeur w de la base du transistor bipolaire.

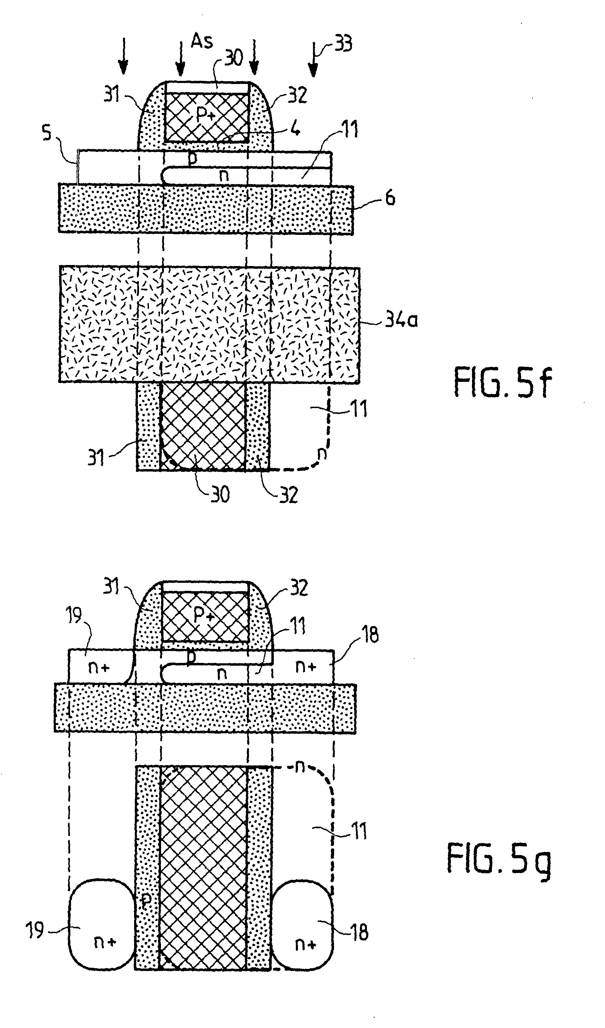

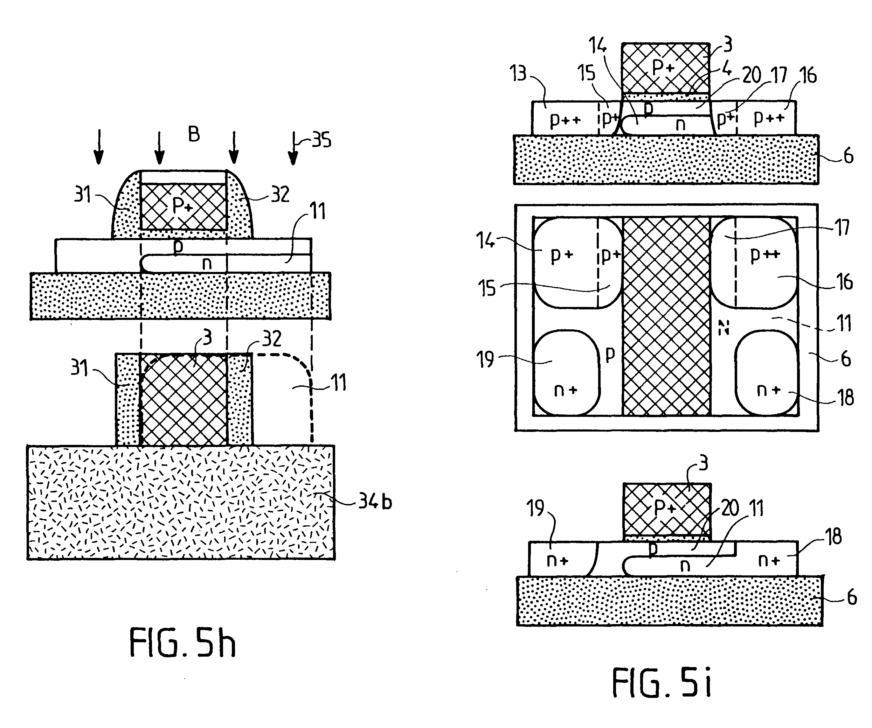

L'étape suivante, illustrée sur la figure 5f, est analogue à celle qui a été décrite en relation avec la figure 4e. Dans cette variante, les espaceurs 31 et 32 jouent le rôle des parties débordantes de la table de nitrure 25 de la figure 4e. On forme ainsi par implantation d'Arsenic, par exemple, les régions surdopées N⁺, 18 et 19, illustrées sur la figure 5g, la région 19 étant de ce fait à distance de l'extrémité de la couche enterrée 11 formant le collecteur intrinsèque du transistor bipolaire.

L'étape illustrée sur la figure 5h est analogue à celle qui a été décrite en relation avec la figure 4g. Le masque 34a a été gravé et un autre masque 34b est disposé de façon à masquer la deuxième zone d'extrémité de la région de grille ainsi que les régions 18 et 19 de type N⁺. Une première implantation de bore est effectuée dans une première zone d'implantation située de part et d'autre des espaceurs 31 et 32. Ces espaceurs sont ensuite gravés, puis une deuxième implantation de bore est effectuée dans une deuxième zone d'implantation prolongeant la première zone d'implantation jusqu'aux bornes de la grille 3, ce qui permet d'obtenir les régions de dopage non uniformes 14, 15, 16 et 17, illustrées sur la figure 5i.

La structure semi-conductrice illustrée sur cette figure Si diffère de celle illustrée sur les figures 1 à 3, par le fait que l'extrémité de la couche enterrée 11 de type N est en contact avec la région implantée 15 de type P⁺. Néanmoins, l'homme du métier comprendra aisément que ceci n'a aucun effet sur le fonctionnement du transistor à effet de champ ou du transistor bipolaire, et d'une façon plus générale, sur le fonctionnement du composant électronique dans sa globalité. Par ailleurs, cette couche enterrée N s'étend jusqu'au bord du substrat 5.

Le procédé de fabrication selon l'invention est compatible avec une technologie de fabrication du type BiCMOS, car il est possible d'utiliser des masques identiques pour la fabrication de ces différents types de transistors, notamment en ce qui concerne le dépôt de l'oxyde de grille et la fabrication des régions de grille.

Par ailleurs, une telle structure est également compatible avec une technologie du type BiCMOS, car le substrat ne sert pas d'émetteur commun.

Le composant électronique selon l'invention peut être utilisé simplement en tant que transistor à effet de champ à grille isolée. Dans ce cas, il serait uniquement nécessaire de prévoir trois métallisations situées respectivement sur les régions de drain, source et grille.

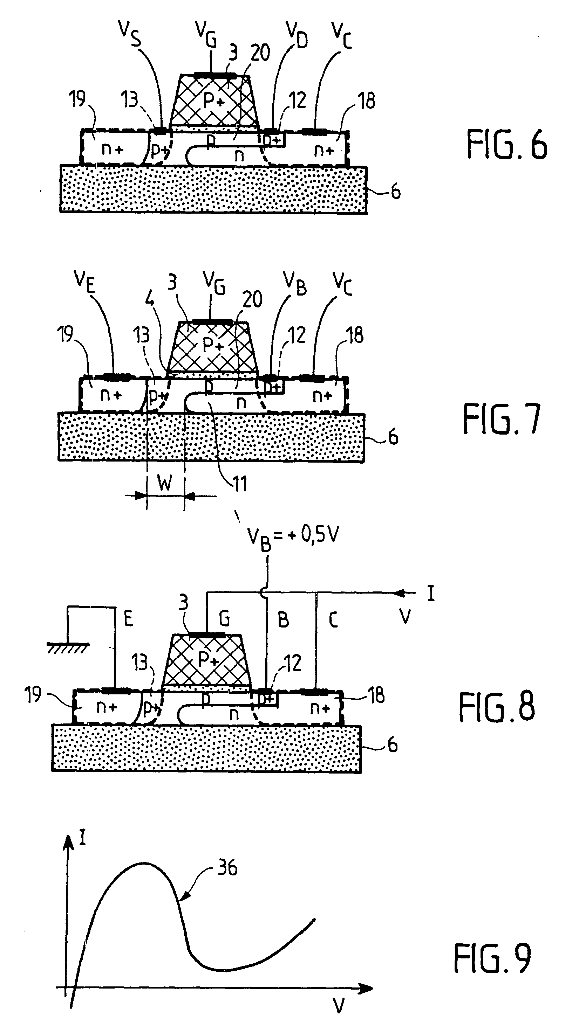

La figure 6 illustre une configuration du composant fonctionnant comme un transistor à grille isolée à canal P. V_{S}, V_{G} et V_{D} désignent respectivement les tensions de source, grille et drain. Sous une tension de grille nulle, le transistor est bloqué par une déplétion complète du canal. Cette déplétion complète du canal se produit sous tension de grille nulle lorsque l'épaisseur de la couche 20 est inférieure ou égale à 1000 Ångströms environ. Au-delà, il est avantageux d'utiliser en outre une polarisation du collecteur positive, ce qui aura pour effet, dans le cas présent, de repousser les trous en-dehors du canal et de dépléter celui-ci. Bien entendu, il convient d'ajouter aux trois métallisations de base du composant électronique selon l'invention, une quatrième métallisation sur la région de collecteur extrinsèque 18.

En fonctionnement, la tension de grille est négative et la tension de collecteur V_{C} est maintenue constante (par exemple +1,5 V). Le transistor fonctionne alors en mode d'accumulation.

Bien entendu, dans le cas où le composant électronique comporterait un transistor à effet de champ à grille isolée à canal N, il conviendrait d'inverser le signe de toutes les tensions de polarisation et de prévoir notamment une tension de collecteur négative. On obtiendrait alors un transistor NMOS à canal déplété sous tension de grille nulle, ce qui est totalement inhabituel dans ce domaine. Il est à souligner ici que la fonction transistor MOS de ce composant électronique est remplie par un transistor fonctionnant en mode d'accumulation, ce qui est très intéressant sur un substrat sur isolant, car plus résistant à l'effet d'avalanche notamment, bien connu de l'homme du métier.

Le composant selon l'invention peut également être utilisé en tant que transistor bipolaire seul. Dans ce cas, il est nécessaire d'avoir uniquement les trois métallisations de base, à savoir sur les régions de collecteur, émetteur et base. Le transistor fonctionne alors comme un transistor bipolaire latéral avec une bonne performance électrique, car l'épaisseur de la base w a pu être ajustée selon l'invention à des valeurs très faibles.

Par ailleurs, ce transistor bipolaire peut être contrôlé sur sa base par le transistor à effet de champ comme illustré sur la figure 7. En effet, la résistance d'accès de la base peut être réduite moyennant une polarisation de grille V_{G} négative (dans le cas d'un transistor à effet de champ à canal P), ce qui a pour effet de créer une couche d'accumulation, très peu résistive, dans la couche commune 20 au-dessous de la grille. Des essais ont montré que le gain en courant d'un tel transistor est de l'ordre de 100.

Bien entendu, dans le cas d'un transistor bipolaire de type PNP, associé à un transistor à effet de champ à canal N, il conviendrait d'appliquer une polarisation de grille positive choisie.

La structure semi-conductrice selon l'invention, peut être utilisée globalement en tant que composant à résistance dynamique négative, comme illustré sur la figure 8. Un tel composant est équipé de quatre métallisations sur les régions de grille, drain (et base), d'une part, et d'émetteur, collecteur, d'autre part. A cet effet, il est particulièrement avantageux de court-circuiter les contacts métalliques de la grille et du collecteur en disposant par exemple une métallisation commune à ces deux régions.

La caractéristique négative courant I-tension V sera observée au niveau du collecteur. Lorsque la tension V est nulle, le courant I est négatif. Si la tension V augmente, le transistor bipolaire se met à conduire, car la jonction émetteur-base est polarisée en direct (V_{B} = + 0,5 Volt environ). La différence de potentiel collecteur-base positive, polarise la jonction collecteur-base en inverse. Par conséquent, le courant I devient positif et augmente jusqu'au niveau de saturation. De plus, la polarisation de la grille du transistor à effet de champ augmente, car elle est directement égale à la tension de collecteur qui est elle-même égale à la tension V. Il en résulte une déplétion du canal, donc une coupure graduelle du passage du courant dans la base du transistor bipolaire. En conséquence, le courant I décroît dès le début de la déplétion du canal. L'augmentation du courant I à tension V élevée, sera due soit au phénomène de perçage de la base, soit à l'avalanche dans la jonction collecteur-base.

Des essais ont pu mettre en évidence une décroissance abrupte 36 du courant I de l'ordre de 6 décades (figure 9). L'amplitude de cette décroissance dépend de la valeur de la tension V_{B}.

Le maintien de la tension de grille et de celle du collecteur à une valeur choisie commune V (que l'on augmente dans le cas présent), a été jugé préférentiel. Néanmoins, une telle condition n'est pas absolument nécessaire. En effet, la configuration de résistance négative peut également être obtenue au niveau du collecteur en fixant la tension de grille à une valeur choisie (pour dépléter partiellement le canal), voire en n'appliquant aucune tension sur cette grille (grille "flottante", la région saillante pouvant alors ne pas être équipée d'une métallisation). Dans ce cas, seule l'augmentation de la tension collecteur V conduira à la déplétion du canal par le biais de l'extension de la zone de charge d'espace de la jonction PN formée par les couches 20 et 11 qui sera d'autant plus polarisée en inverse que la tension de collecteur augmentera.

En raison du mode de représentation simplifiée des figures 6 à 8, les contacts de source et drain (base) ont été représentés pour plus de clarté très près de la région saillante bien qu'ils soient en réalité disposés au contact de la quasi totalité des régions concernées.

L'invention a permis d'obtenir, dans une seule structure, ayant une forme géométrique très compacte, les fonctions d'un transistor à effet de champ à grille isolée, et bipolaire, ainsi que celle d'une structure à résistance dynamique négative. Dans cette structure très compacte, la localisation du transport du courant s'effectue sur deux niveaux, à savoir le niveau supérieur ou apparaît le canal du transistor à effet de champ, ainsi que le transport du courant de base du transistor bipolaire (couche commune 20) et le niveau inférieur où a lieu l'action bipolaire (émetteur 19, base d'épaisseur w et collecteur 11,18).

Le transistor bipolaire est particulièrement performant et utilisable en technologie BiCMOS. Le transistor à effet de champ fonctionne en accumulation et le composant à résistance dynamique négative permet de réaliser un point mémoire statique de petites dimensions, aussi bien que des générateurs de signaux ou des circuits de régulation automatique/stabilisation d'un point de fonctionnement. Toutes ces fonctions trouvent directement leurs applications dans les circuits intégrés pour les systèmes de télécommunication.

## Revendications

1. Composant électronique comprenant, intégrées au sein d'une seule et même structure semi-conductrice (1), une première zone semi-conductrice (12, 13, 3, 4, 20) formant les régions de drain, de source et de grille d'un transistor à effet de champ à grille isolée à canal P ou N, et une deuxième zone semi-conductrice (12, 20, 18, 19, 11) formant les régions d'émetteur, de base et de collecteur d'un transistor bipolaire latéral du type NPN si le transistor à effet de champ est à canal P et du type PNP si le transistor à effet de champ est à canal N, les deux zones possédant une couche semi-conductrice commune (20) du même type de conductivité que celle de la région de base, incluant la région de canal du transistor à effet de champ et/ou une région de circulation du courant de base du transistor bipolaire, les deux zones formant ensemble une structure capable de résistance dynamique négative obtenue au niveau du collecteur par déplétion de la région de canal.

2. Composant selon la revendication 1, caractérisé par le fait que la structure semi-conductrice comporte un bloc semi-conducteur (2), supportant la grille saillante isolée (3) du transistor à effet de champ,
par le fait que la couche semi-conductrice commune (20) s'étend dans la partie supérieure du bloc sous la grille (3),
par le fait que le reste de la première zone s'étend de part et d'autre de ladite couche commune, tandis que la deuxième zone se situe partiellement dans la partie inférieure du bloc, décalée latéralement par rapport à la première zone.

3. Composant selon l'une des revendications précédentes, caractérisé par le fait qu'il comporte un collecteur intrinsèque (11) s'étendant dans la région inférieure du bloc jusqu'à une distance prédéterminée (w) de la région d'émetteur (19) du transistor bipolaire en définissant ainsi l'épaisseur (w) de la base intrinsèque du transistor bipolaire.

4. Composant selon la revendication 3, caractérisé par le fait que l'épaisseur de la base intrinsèque submicronique.

5. Composant selon l'une des revendications précédentes, caractérisé par le fait qu'il comprend un contact commun (12) pour la base extrinsèque du transistor bipolaire et le drain du transistor à effet de champ, ainsi que des contacts distincts pour l'émetteur (19) et le collecteur extrinsèque (18) du transistor bipolaire et la source (13) du transistor à effet de champ.

6. Composant selon l'une des revendications précédentes, caractérisé par le fait que la structure semi-conductrice (1) comporte :
- un substrat semi-conducteur (5) ayant un premier type de conductivité (P),
- une couche isolante (4) située sur une partie d'une première face du substrat, et supportant une première région semi-conductrice saillante (3), formant la région de grille du transistor à effet de champ, et ayant le premier type de conductivité (P⁺),
- une première paire de régions semi-conductrices (12, 13), localisées au sein du substrat (5), de part et d'autre d'une première zone d'extrémité (9) de la région saillante (3), formant respectivement d'une part, la région de source (13) et, d'autre part, la région de drain ou celle de base extrinsèque (12), et ayant le premier type de conductivité (P⁺, P⁺⁺),
- une deuxième paire de régions semi-conductrices (18, 19), localisées au sein du substrat (5), de part et d'autre d'une deuxième zone d'extrémité (10) de la région saillante (3), opposée à la première zone d'extrémité (9), formant respectivement la région d'émetteur (19) et celle de collecteur extrinsèque (18), et ayant un deuxième type de conductivité (N⁺) opposé au premier,
- une couche enterrée semi-conductrice (11), ayant le deuxième type de conductivité (N), et s'étendant à distance de la première face du substrat en étant en contact avec la région de la deuxième paire (18) formant le collecteur extrinsèque, et à distance de l'autre région (19) de cette deuxième paire,
- une première métallisation disposée au contact de la région de la première paire (12) formant drain ou base extrinsèque, et
- au moins deux autres métallisations disposées respectivement au contact des deux régions (18, 19) de la deuxième paire ou au contact, d'une part, de la région (12) formant la source et, d'autre part, de la région saillante (3).

7. Composant selon la revendication 6, caractérisé par le fait que la région saillante (3) et les quatre régions des deux paires (12, 13, 18, 19) sont surdopées.

8. Composant selon la revendication 6 ou 7, caractérisé par le fait que les quatre régions des deux paires (12, 13, 18, 19) s'étendent depuis la première face du substrat jusqu'à la face opposée.

9. Composant selon l'une des revendications 1 à 8, caractérisé par le fait que le substrat de la structure semi-conductrice (1) est un substrat sur isolant.

10. Composant selon l'une des revendications précédentes, pour son utilisation en tant que transistor à effet de champ, caractérisé par le fait qu'il comporte au moins trois contacts métalliques sur les régions de grille (3), source (13) et drain (12).

11. Utilisation du composant selon la revendication 10, caractérisée par le fait que, le composant comportant un quatrième contact métallique sur la région de collecteur (18), on applique une tension de polarisation choisie (V_{C}) sur la région de collecteur, positive dans le cas d'un transistor à effet de champ à canal P et négative dans le cas d'un transistor à effet de champ à canal N.

12. Composant selon l'une des revendications 1 à 9, caractérisé par le fait qu'il comporte au moins trois contacts métalliques sur les régions de base (12), collecteur (18) et émetteur (19).

13. Utilisation du composant selon la revendication 12, caractérisée par le fait que le composant comportant un quatrième contact métallique sur la région de grille (3), on applique une tension de polarisation choisie sur la grille, négative dans le cas d'un transistor à effet de champ à canal P, positive dans le cas d'un transistor à effet de champ à canal N.

14. Composant selon l'une des revendications 1 à 9, présentant une configuration de résistance dynamique négative, caractérisé par le fait qu'il comporte des contacts métalliques au moins sur les régions de drain, base, collecteur et émetteur.

15. Utilisation du composant selon la revendication 14, caractérisée par le fait que, la jonction émetteur-base du transistor bipolaire étant polarisée en direct, on polarise la jonction collecteur-base en inverse.

16. Utilisation selon la revendication 15, caractérisée par le fait que, le composant comportant en outre un contact métallique sur la région de grille, on applique une polarisation choisie sur la grille.

17. Utilisation selon la revendication 15 ou 16, caractérisée par le fait que la résistance dynamique négative(36) est obtenue à partir de la relation courant-tension collecteur (I, V).

18. Procédé de fabrication d'une structure semi-conductrice selon la revendication 1, intégrant un transistor à effet de champ à grille isolée et un transistor bipolaire latéral, dans lequel :
a) on réalise, sur une première face d'un substrat semi-conducteur ayant un premier type de conductivité (P), une région saillante isolée (3), formant la région de grille du transistor à effet de champ et ayant également le premier type de conductivité (P⁺), et, dans la partie inférieure du substrat, une couche enterrée (11) ayant un deuxième type de conductivité (N), opposé au premier, et s'étendant dans une portion de la partie inférieure du substrat, au moins sous la région saillante,
b) on implante dans le substrat, une première paire de régions semi-conductrices (12, 13), localisées de part et d'autre d'une première zone d'extrémité (9) de la région saillante (3), formant respectivement, d'une part, la région de source et, d'autre part. la région de drain ou celle de base extrinsèque, et ayant le premier type de conductivité (P⁺, P⁺⁺),
c) on implante dans le substrat, une deuxième paire de régions semi-conductrices (18, 19), ayant le deuxième type de conductivité (N⁺), localisées de part et d'autre d'une deuxième zone d'extrémité (10) de la région saillante (3), opposée à la première (9); l'une de ces régions (19), située à l'extérieur de la couche enterrée (11), formant la région d'émetteur, l'autre région (18), située au contact de ladite couche enterrée (11), formant la région de collecteur extrinsèque, et
d) on métallise la région de la première paire formant drain ou base extrinsèque (12), et au moins les deux régions de la deuxième paire (18, 19) ou, d'une part, la région (13) formant la source et, d'autre part, la région saillante (3) formant la grille.

19. Procédé selon la revendication 18, caractérisé par le fait que les étapes d'implantation a) et b) comportent des surdopages.

20. Procédé selon la revendication 18 ou 19, caractérisé par le fait que, dans l'étape a),
a1) on implante au sein du substrat une région enterrée (21), s'étendant à distance de la première face du substrat et ayant le deuxième type de conductivité (N),
a2) on forme sur le substrat ainsi implanté, un empilement contenant une couche isolante (23) surmontée d'une couche semi-conductrice (24) ayant le premier type de conductivité (P⁺), elle-même surmontée d'une couche supérieure (25, 30) apte à former un masque d'implantation,
a3) on retire au moins une portion de cet empilement pour mettre à nu la portion correspondante de la première phase du substrat et pour définir au moins un premier flanc ou borne (7) de la région saillante (3),
a4) on effectue une implantation choisie de dopants de la structure ainsi obtenue pour délimiter ladite région enterrée (21) et former ladite couche enterrée (11).

21. Procédé selon la revendication 20, caractérisé par le fait que l'on effectue dans l'étape a4) ladite implantation choisie, sensiblement perpendiculairement à la première face du substrat.

22. Procédé selon la revendication 21, caractérisé par le fait que postérieurement à l'étape a4), on retire une autre portion de l'empilement pour mettre à nu la portion correspondante de la première phase du substrat et pour définir le deuxième flanc (8) de la région saillante, opposé au premier (7),
par le fait que l'on dispose des régions latérales isolantes (31, 32) au contact des deux flancs, ces régions latérales isolantes ayant une largeur prédéterminée au niveau de la première phase du substrat,
par le fait que, dans l'étape c), on implante les deux régions (18, 19) de la deuxième paire de part et d'autre des régions latérales isolantes (31, 32).

23. Procédé selon la revendication 22, caractérisé par le fait que dans l'étape d), on effectue, dans une première zone d'implantation, située de part et d'autre des régions latérales isolantes (31, 32), et au voisinage de ladite première zone d'extrémité (9) de la région saillante (3), une première implantation choisie de dopants propre à surdoper (P⁺) ladite première zone d'implantation par rapport au substrat,
par le fait que l'on retire les régions latérales isolantes et on effectue dans une deuxième zone d'implantation prolongeant la première jusqu'aux deux flancs de la région saillante, une deuxième implantation du même type que la première, ce qui permet d'obtenir les deux régions (12, 13) de la première paire avec un dopage non uniforme (P⁺, P⁺⁺).

24. Procédé selon la revendication 20, caractérisé par le fait qu'on retire une autre portion de l'empilement pour, d'une part, mettre à nu la portion correspondante de la première face du substrat et pour définir le deuxième flanc (8) de la région saillante (3), opposé au premier (7) et, d'autre part, faire déborder de la face supérieure de la région saillante ladite couche supérieure de masque (25) d'une distance prédéterminée,
par le fait que l'on effectue ladite implantation choisie, sur la structure ainsi obtenue munie du masque débordant, selon une direction oblique par rapport à la première face du substrat.

25. Procédé selon la revendication 24, caractérisé par le fait que l'on implante les deux régions de la deuxième paire (18, 19) en effectuant une implantation choisie de dopants sensiblement perpendiculairement à la première face du substrat, sur la structure munie du masque débordant fixé sur la grille.

26. Procédé selon la revendication 24 ou 25, caractérisé par le fait que dans l'étape d), on effectue, dans un première zone d'implantation, située de part et d'autre des bords du masque débordant, et au voisinage de ladite première zone d'extrémité (9) de la région saillante (3), une première implantation choisie de dopants propre à surdoper (P⁺) ladite première zone d'implantation par rapport au substrat,
par le fait que l'on retire le masque débordant et qu' on effectue dans une deuxième zone d'implantation prolongeant la première jusqu'aux deux flancs de la région saillante, une deuxième implantation du même type que la première, ce qui permet d'obtenir les deux régions (12, 13) de la première paire avec un dopage non uniforme (P⁺, P⁺⁺).

## Patentansprüche

1. Elektronikbauteil, das in einer einzigen und selben Halbleiterstruktur (1) integriert eine erste Halbleiterzone (12, 13, 3, 4, 20), die die Drain-, Quellenbereiche und Bereiche der Steuerelektrode eines Feldeffekttransistors mit isolierter Steuerelektrode mit einem Kanal P oder N bildet, und eine zweite Halbleiterzone (12, 20, 18, 19, 11) umfaßt, die die Sender-, Basis- und Kollektorbereiche eines seitlichen Bipolar-Transistors vom Typ NPN bildet, wenn der Feldeffekttransistor einen Kanal P aufweist, und vom Typ PNP, wenn der Feldeffekttransistor einen Kanal N aufweist, wobei die beiden Zonen eine gemeinsame Halbleiterschicht (20) von demselben Konduktivitätstyp wie jene des Basisbereichs besitzen, wobei der Kanalbereich des Feldeffekttransistors und/oder ein Umlaufbereich des Basisstroms des Bipolar-Transistors eingeschlossen ist, wobei die beiden Zonen gemeinsam eine Struktur bilden, die zu einem dynamischen, negativen Widerstandsverhalten in der Lage ist, welche im Bereich des Kollektors durch Entleerung des Kanalbereichs erhalten wird.

2. Bauteil nach Anspruch 1, dadurch gekennzeichnet, daß die Halbleiterstruktur einen Halbleiterblock (2) umfaßt, der die vorspringende isolierte Steuerelektrode (3) des Feldeffekttransistors trägt;
daß sich die gemeinsame Halbleiterschicht (20) in dem oberen Teil des Blocks unter der Steuerelektrode (3) erstreckt,
daß sich der Rest der ersten Zone, beiderseits dieser gemeinsamen Schicht erstreckt und sich die zweite Zone, teilweise in dem unteren Teil des Blocks befindet, der seitlich in bezug auf die erste Zone versetzt ist.

3. Bauteil nach einem der vorhergehenden Ansprüche, dadurch gekennzeichnet, daß es einen inneren Kollektor (11) umfaßt, der sich in dem unteren Bereich des Blocks bis zu einem vorbestimmten Abstand (w) zu dem Senderbereich (19) des Bipolar-Transistors erstreckt.

4. Bauteil nach Anspruch 3, dadurch gekennzeichnet, daß die Dicke der inneren Basis unter einem Mikrometer liegt.

5. Bauteil nach einem der vorhergehenden Ansprüche, dadurch gekennzeichnet, daß es einen gemeinsamen Kontakt (12) für die äußere Basis des Bipolar-Transistors und den Drain des Feldeffekttransistors sowie getrennte Kontakte für den Sender (19) und den äußeren Kollektor (18) des Bipolar-Transistors und die Quelle (13) des Feldeffekttransistors umfaßt.

6. Bauteil nach einem der vorhergehenden Ansprüche, dadurch gekennzeichnet, daß die Halbleiterstruktur (1) umfaßt:
- ein Halbleitersubstrat (5), das einen ersten Konduktivitätstyp (P) aufweist,
- eine Isolierschicht (4), die sich auf einem Teil einer ersten Seite des Substrats befindet und einen ersten vorspringenden Halbleiterbereich (3) trägt, der den Isolierbereich des Feldeffekttransistors bildet und den ersten Konduktivitätstyp (P⁺) aufweist,
- ein erstes Paar von Halbleiterbereichen (12, 13), die in dem Substrat (5) angeordnet sind, beiderseits einer ersten Endzone (9) des vorspringenden Bereichs (3), der einerseits den Quellenbereich (13) bzw. andererseits den Drainbereich oder den äußeren Basisbereich (12) bildet und den ersten Konduktivitätstyp (P⁺, P⁺⁺) aufweist,
- ein zweites Paar von Halbleiterbereichen (18, 19), die in dem Substrat (5) angeordnet sind, beiderseits einer zweiten Endzone (10) des vorspringenden Bereichs (3) gegenüber der ersten Endzone (9), die den Senderbereich (19) bzw. den äußeren Kollektorbereich bildet (18) und den zweiten Konduktivitätstyp (N⁺) gegenüber dem ersten aufweist,
- eine beerdigte Halbleiterschicht (11), die den zweiten Konduktivitätstyp (N) aufweist und sich in einem Abstand zu der ersten Fläche des Substrats erstreckt, indem sie mit dem Bereich des zweiten Paars (18) in Kontakt ist, der den äußeren Kollektor bildet, und in einem Abstand zu dem anderen Bereich (19) dieses zweiten Paars erstreckt,
- einen ersten Metallbelag, der in Kontakt mit dem Bereich des ersten Paars (12), der den Drain oder die äußere Basis bildet, angeordnet ist, und
- mindestens zwei weitere Metallbeläge, die jeweils in Kontakt mit den beiden Bereichen (18, 19) des zweiten Paars oder in Kontakt mit einerseits dem Bereich (12), der die Quelle bildet, und andererseits dem vorspringenden Bereich (3) angeordnet sind.

7. Bauteil nach Anspruch 6, dadurch gekennzeichnet, daß der vorspringende Bereich (3) und die vier Bereiche der beiden Paare (12, 13, 18, 19) überdotiert sind.

8. Bauteil nach Anspruch 6 oder 7, dadurch gekennzeichnet, daß sich die vier Bereiche der beiden Paare (12, 13, 18, 19) von der ersten Fläche des Substrats bis zu der gegenüberliegenden Seite erstrecken.

9. Bauteil nach einem der Ansprüche 1 bis 8, dadurch gekennzeichnet, daß das Substrat der Halbleiterstruktur (1) ein Substrat auf Isoliermittel ist.

10. Bauteil nach einem der vorhergehenden Ansprüche zur Verwendung als Feldeffekttransistor, dadurch gekennzeichnet, daß es mindestens drei metallische Kontakte auf den Bereichen der Steuerelektrode (3), der Quelle (13) und des Drains (12) umfaßt.

11. Verwendung des Bauteils nach Anspruch 10, dadurch gekennzeichnet, daß das Bauteil einen vierten metallischen Kontakt auf dem Bereich des Kollektors (18) umfaßt und eine ausgewählte Polarisationsspannung (V_{C}) an den Kollektorbereich angelegt wird, die bei einem Feldeffekttransistor mit Kanal P positiv und bei einem Feldeffekttransistor mit Kanal N negativ ist.

12. Bauteil nach einem der Ansprüche 1 bis 9 zur Verwendung als Bipolar-Transistor, dadurch gekennzeichnet, daß es mindestens drei metallische Kontakte auf den Basis- (12), Kollektor- (18) und Senderbereichen (19) umfaßt.

13. Verwendung des Bauteils nach Anspruch 12, dadurch gekennzeichnet, daß das Bauteil einen vierten metallischen Kontakt auf seinem Bereich der Steuerelektrode (3) umfaßt und eine ausgewählte Polarisationsspannung an die Steuerelektrode angelegt wird, die bei einem Feldeffekttransistor mit Kanal P negativ und bei einem Feldeffekttransistor mit Kanal N positiv ist.

14. Bauteil nach einem der Ansprüche 1 bis 9 zur Verwendung als Bauteil, das eine Konfiguration des dynamischen, negativen Widerstandsverhaltens aufweist, dadurch gekennzeichnet, daß es metallische Kontakte zumindest auf den Bereichen des Drains und der Basis, den Kollektor- und Senderbereichen umfaßt.

15. Verwendung des Bauteils nach Anspruch 14, dadurch gekennzeichnet, daß die Verbindung Sender-Basis des Bipolar-Transistors direkt polarisiert wird und die Verbindung Kollektor-Basis umgekehrt polarisiert wird.

16. Verwendung nach Anspruch 15, dadurch gekennzeichnet, daß das Bauteil femer einen metallischen Kontakt auf dem Bereich der Steuerelektrode umfaßt und eine ausgewählte Polarisierung an die Steuerelektrode angelegt wird.

17. Verwendung nach Anspruch 15 oder 16, dadurch gekennzeichnet, daß das dynamische, negative Widerstandsverhalten (36) aus dem Strom-Spannungs-Verhältnis des Kollektors (I, V) erhalten wird.

18. Verfahren zur Herstellung einer Halbleiterstruktur nach Anspruch 1, die einen Feldeffekttransistor mit isolierter Steuerelektrode und einen seitlichen Bipolar-Transistor umfaßt, bei dem:
a) auf einer ersten Seite eines Halbleitersubstrats, das einen ersten Konduktivitätstyp (P) aufweist, ein vorspringender isolierter Bereich (3) hergestellt wird, der den Bereich der Steuerelektrode des Feldeffekttransistors bildet und ebenfalls den ersten Konduktivitätstyp (P⁺) aufweist, und in dem unteren Teil des Substrats eine beerdigte Schicht (11) hergestellt wird, die einen zweiten Konduktivitätstyp (N) aufweist, der dem ersten gegenüberliegt, und die sich in einem Abschnitt des unteren Teils des Substrats zumindest unter dem vorspringenden Bereich erstreckt,
b) in das Substrat ein erstes Paar von Halbleiterbereichen (12, 13) eingepflanzt bzw. eingebracht wird, die beiderseits einer ersten Endzone (9) des vorspringenden Bereichs (3) angeordnet sind, der einerseits den Quellenbereich bzw. andererseits den Drainbereich oder jenen der äußeren Basis bildet, welche Halbleiterbereiche den ersten Konduktivitätstyp (P⁺, P⁺⁺) aufweisen,
c) in das Substrat ein zweites Paar von Halbleiterbereichen (18, 19) eingepflanzt wird, die den zweiten Konduktivitätstyp (N⁺) aufweisen und beiderseits einer zweiten Endzone (10) des vorspringenden Bereichs (3), die der ersten (9) gegenüberliegt, angeordnet sind; wobei einer dieser Bereiche (19), der sich außerhalb der beerdigten Schicht (11) befindet, den Senderbereich bildet, wobei der andere Bereich (18), der sich in Kontakt mit dieser beerdigten Schicht (11) befindet, den äußeren Kollektorbereich bildet, und
d) der Bereich des ersten Paars, der den Drain oder die äußere Basis (12) bildet, und zumindest die beiden Bereiche des zweiten Paars (18, 19) oder einerseits der die Quelle bildende Bereich (13) und andererseits der die Steuerelektrode bildende vorspringende Bereich (3) mit Metall bedeckt werden.

19. Verfahren nach Anspruch 18, dadurch gekennzeichnet, daß die Schritte der Einpflanzung a) und b) Überdotierungen umfassen.

20. Verfahren nach Anspruch 18 oder 19, dadurch gekennzeichnet, daß im Schritt a):
a1) in das Substrat ein beerdigter Bereich (21) eingepflanzt wird, der sich in einem Abstand zu der ersten Fläche des Substrats erstreckt und den zweiten Konduktivitätstyp (N) aufweist,
a2) auf dem auf diese Weise eingepflanzten Substrat ein Stapel gebildet wird, der eine Isolierschicht (23) enthält, über der eine Halbleiterschicht (24) angebracht ist, die den ersten Konduktivitätstyp (P⁺) aufweist, über welcher selbst eine obere Schicht (25, 30) angebracht ist, die eine Einpflanzmaske bilden kann,
a3) zumindest ein Abschnitt dieses Stapels zurückgezogen wird, um den Abschnitt freizulegen, der der ersten Phase des Substrats entspricht, und um zumindest eine erste Seite oder Grenze (7) des vorspringenden Bereichs (3) zu definieren,
a4) ein ausgewähltes Einpflanzen von Dotiermitteln für die auf diese Weise erhaltene Struktur vorgenommen wird, um den beerdigten Bereich (21) zu begrenzen und die beerdigte Schicht (11) zu bilden.

21. Verfahren nach Anspruch 20, dadurch gekennzeichnet, daß im Schritt a4) die ausgewählte Einpflanzung des beerdigten Bereichs im wesentlichen senkrecht zu der ersten Fläche des Substrats erfolgt.

22. Verfahren nach Anspruch 21, dadurch gekennzeichnet, daß nach dem Schritt a4) ein weiterer Abschnitt des Stapels zurückgezogen wird, um den entsprechenden Abschnitt der ersten Phase des Substrats freizulegen und die zweite Seite (8) des vorspringenden Bereichs zu definieren, die der ersten (7) gegenüberliegt,
daß seitliche Isolierbereiche (31, 32) in Kontakt mit den beiden Seiten angeordnet werden, wobei diese seitlichen Isolierbereiche eine vorbestimmte Breite auf Höhe der ersten Phase des Substrats aufweisen,
daß im Schritt c) die beiden Bereiche (18, 19) des zweiten Paars beiderseits der seitlichen Isolierbereiche (31, 32) eingepflanzt werden.

23. Verfahren nach Anspruch 22, dadurch gekennzeichnet, daß im Schritt d) in einer ersten Einpflanzzone, die sich beiderseits der seitlichen Isolierbereiche (31, 32) befindet, und in der Nähe der ersten Endzone (9) des vorspringenden Bereichs (3) eine erste ausgewählte Einpflanzung von Dotiermitteln erfolgt, um die erste Einpflanzzone in bezug auf das Substrat überzudotieren (P⁺),
daß die seitlichen Isolierbereiche zurückgezogen werden und in einer zweiten Einpflanzzone, die die erste bis zu den beiden Grenzen des vorspringenden Bereichs verlängert, ein zweites Einpflanzen desselben Typs wie das erste erfolgt, wodurch es möglich ist, die beiden Bereiche (12, 13) des ersten Paars mit einer nicht einheitlichen Dotierung (P⁺⁺, P⁺) zu erhalten.

24. Verfahren nach Anspruch 20, dadurch gekennzeichnet, daß ein weiterer Abschnitt des Stapels zurückgezogen wird, um einerseits den entsprechenden Abschnitt der ersten Fläche des Substrats freizulegen und die zweite Seite (8) des vorspringenden Bereichs (3), die der ersten (7) gegenüberliegt, zu definieren und andererseits über die obere Fläche dieses vorspringenden Bereichs die die obere Maskenschicht (25) um einen vorbestimmten Abstand überstehen zu lassen,
daß die ausgewählte Einpflanzung auf der auf diese Weise erhaltenen Struktur, die mit der überstehenden Maske versehen ist, entlang einer schrägen Richtung in bezug auf die erste Fläche des Substrats erfolgt.

25. Verfahren nach Anspruch 24, dadurch gekennzeichnet, daß die beiden Bereiche des zweiten Paars (18, 19) eingepflanzt werden, indem eine ausgewählte Einpflanzung von Dotiermitteln im wesentlichen senkrecht auf die erste Fläche des Substrats auf der Struktur, die mit der auf der Steuerelektrode befestigten überstehenden Maske versehen ist, erfolgt.

26. Verfahren nach Anspruch 24 oder 25, dadurch gekennzeichnet, daß im Schritt d) in einer ersten Einpflanzzone, die sich beiderseits der Ränder der überstehenden Maske und in der Nähe der ersten Endzone (9) des vorspringenden Bereichs (3) befindet, ein erstes ausgewähltes Einpflanzen von Dotiermitteln durchgeführt wird, welches die erste Einpflanzzone in bezug auf das Substrat überdotieren (P⁺) kann,
daß die überstehende Maske zurückgezogen wird und in einer zweiten Einpflanzzone, die die erste bis zu den Seiten des vorspringenden Bereichs verlängert, ein zweites Einpflanzen desselben Typs wie das erste vorgenommen wird, wodurch es möglich ist, die beiden Bereiche (12, 13) des ersten Paars mit einer nicht einheitlichen Dotierung (P⁺, P⁺⁺) zu erhalten.

## Claims

1. Electronic component comprising, integrated within the same single semiconductor structure (1), a first semiconductor area (12, 13, 3, 4, 20) forming the drain, source and gate regions of a P- or N-channel insulated-gate field-effect transistor, and a second semiconductor area (12, 20, 18, 19, 11) forming the emitter, base and collector regions of an NPN-type lateral bipolar transistor if the field-effect transistor has a P channel and a PNP-type lateral bipolar transistor if the field-effect transistor has an N channel, the two areas having a common semiconductor layer (20) which has the same type of conductivity as that of the base region, including the channel region of the field-effect transistor and/or a region for the flow of the base current of the bipolar transistor, the two areas together forming a structure capable of negative dynamic resistance obtained in the region of the collector by depletion of the channel region.

2. Component according to Claim 1, characterised in that the semiconductor structure includes a semiconductor block (2) supporting the insulated projecting gate (3) of the field-effect transistor,
in that the common semiconductor layer (20) extends into the upper part of the block under the gate (3),
in that the rest of the first area extends on either side of the said common layer, while the second area lies partially in the lower part of the block, offset laterally with respect to the first area.

3. Component according to one of the preceding claims, characterised in that it includes an intrinsic collector (11) extending into the lower region of the block up to a predetermined distance (w) from the emitter (19) region of the bipolar transistor thus defining the thickness (w) of the intrinsic base of the bipolar transistor.

4. Component according to Claim 3, characterised in that the thickness of the intrinsic base is submicronic.

5. Component according to one of the preceding claims, characterised in that it comprises a common contact (12) for the extrinsic base of the bipolar transistor and the drain of the field-effect transistor as well as the separate contacts for the emitter (19) and the extrinsic collector (18) of the bipolar transistor and the source (13) of the field-effect transistor.

6. Component according to one of the preceding claims, characterised in that the semiconductor structure (1) includes:
- a semiconductor substrate (5) having a first type of conductivity (P),
- an insulating layer (4) situated on a part of a first face of the substrate, and supporting a first projecting semiconductor region (3), forming the gate region of the field-effect transistor, and having the first type of conductivity (P⁺),
- a first pair of semiconductor regions (12, 13), localised within the substrate (5) on either side of a first end area (9) of the projecting region (3), forming respectively, on the one hand, the source region (13) and, on the other hand, the drain region or that of the extrinsic base (12), and having the first type of conductivity (P⁺, P⁺⁺),
- a second pair of semiconductor regions (18, 19), localised within the substrate (5) on either side of a second end area (10) of the projecting region (3), opposite the first end area (9), forming respectively the emitter (19) region and that of the extrinsic collector (18), and having a second type of conductivity (N⁺) opposite to the first,
- a buried semiconductor layer (11), having the second type of conductivity (N), and extending away from the first face of the substrate while being in contact with the region of the second pair (18) forming the extrinsic collector, and away from the other region (19) of this second pair,
- a first metallization arranged in contact with the region of the first pair (12) forming a drain or extrinsic base, and
- at least two other metallizations arranged respectively in contact with the two regions (18, 19) of the second pair or in contact, on the one hand, with the region (12) forming the source and, on the other hand, with the projecting region (3).

7. Component according to Claim 6, characterised in that the projecting region (3) and the four regions of the two pairs (12, 13, 18, 19) are overdoped.

8. Component according to Claim 6 or 7, characterised in that the four regions of the two pairs (12, 13, 18, 19) extend from the first face of the substrate as far as the opposite face.

9. Component according to one of Claims 1 to 8, characterised in that the substrate of the semiconductor structure (1) is a substrate on insulator.

10. Component according to one of the preceding claims, for its use as a field-effect transistor, characterised in that it includes at least three metallic contacts on the gate (3), source (13) and drain (12) regions.

11. Use of the component according to Claim 10, characterised in that, the component including a fourth metallic contact on the collector (18) region, a chosen bias voltage (V_{c}) is applied to the collector region, positive in the case of a P-channel field-effect transistor and negative in the case of an N-channel field-effect transistor.

12. Component according to one of Claims 1 to 9, characterised in that it includes at least three metallic contacts on the base (12), collector (18) and emitter (19) regions.

13. Use of the component according to Claim 12, characterised in that the component including a fourth metallic contact on the gate (3) region, a chosen bias voltage is applied to the gate, negative in the case of a P-channel field-effect transistor, positive in the case of an N-channel field-effect transistor.

14. Component according to one of Claims 1 to 9, exhibiting a negative dynamic resistance configuration, characterised in that it includes metallic contacts at least on the drain, base, collector and emitter regions.

15. Use of the component according to Claim 14, characterised in that, the emitter-base junction of the bipolar transistor being forward biased, the collector-base junction is reverse biased.

16. Use according to Claim 15, characterised in that, the component further including a metallic contact on the gate region, a chosen bias is applied to the gate.

17. Use according to Claim 15 or 16, characterised in that the negative dynamic resistance (36) is obtained from the collector current/voltage relationship (I, V).

18. Method of fabricating a semiconductor structure according to claim 1, integrating an insulated-gate field-effect transistor and a lateral bipolar transistor, in which:
a) on a first face of a semiconductor substrate having a first type of conductivity (P), an insulated projecting region (3) is produced, forming the gate region of the field-effect transistor and also having the first type of conductivity (P⁺), and, in the lower part of the substrate, a buried layer (11) is produced, having a second type of conductivity (N), opposite to the first, and extending into a portion of the lower part of the substrate, at least under the projecting region,
b) into the substrate, a first pair of semiconductor regions (12, 13) is implanted, localised on either side of a first end area (9) of the projecting region (3), forming respectively, on one hand, the source region and, on the other hand, the drain region or that of an extrinsic base, and having the first type of conductivity (P⁺, P⁺⁺),
c) into the substrate, a second pair of semiconductor regions (18, 19) is implanted, having the second type of conductivity (N⁺), localised on either side of a second end area (10) of the projecting region (3), opposite the first (9); one of these regions (19) , situated outside the buried layer (11), forming the emitter region, the other region (18), situated in contact with the said buried layer (11) , forming the extrinsic collector region, and
d) the region of the first pair forming a drain or extrinsic base (12), and at least the two regions of the second pair (18, 19) or, on the one hand, the region (13) forming the source and, on the other hand, the projecting region (3) forming the gate, are metallized.

19. Method according to Claim 18, characterised in that the implantation steps a) and b) include over-dopings.

20. Method according to Claim 18 or 19, characterised in that, in step a),
a1) within the substrate a buried region (21) is implanted, extending away from the first face of the substrate and having the second type of conductivity (N),
a2) on the substrate thus implanted is formed a stack containing an insulating layer (23) surmounted by a semiconductor layer (24) having the first type of conductivity (P⁺), itself surmounted by an upper layer (25, 30) able to form an implantation mask,
a3) at least a portion of this stack is removed in order to lay bare the corresponding portion of the first phase [sic] of the substrate and in order to define at least one first side or terminal (7) of the projecting region (3),
a4) a chosen implantation of dopants of the structure thus obtained is carried out in order to delimit the said buried region (21) and form the said buried layer (11) .

21. Method according to Claim 20, characterised in that in step a4) the said chosen implantation is carried out substantially perpendicularly to the first face of the substrate.

22. Method according to Claim 21, characterised in that, subsequent to step a4), another portion of the stack is removed in order to lay bare the corresponding portion of the first phase [sic] of the substrate and in order to define the second side (8) of the projecting region, opposite to the first (7),
in that insulating lateral regions (31, 32) are arranged in contact with the two sides, these insulating lateral regions having a predetermined width in the region of the first phase [sic] of the substrate,
in that, in step c), the two regions (18, 19) of the second pair are implanted on either side of the insulating lateral regions (31, 32).

23. Method according to Claim 22, characterised in that in step d), a first chosen implantation of dopants suitable for overdoping (P⁺) the said first implantation area with respect to the substrate is carried out, in a first implantation area, situated on either side of the insulating lateral regions (31, 32), and in the vicinity of the said first end area (9) of the projecting region (3) ,
in that the insulating lateral regions are removed and, in a second implantation area prolonging the first up to the two sides of the projecting region, a second implantation of the same type as the first is carried out, which makes it possible to obtain the two regions (12, 13) of the first pair with a non-uniform doping (P⁺, P⁺⁺).

24. Method according to Claim 20, characterised in that another portion of the stack is removed in order, on the one hand, to lay bare the corresponding portion of the first face of the substrate and in order to define the second side (8) of the projecting region (3), opposite to the first (7) and, on the other hand, to cause the said upper masking layer (25) to overlap the upper face of the projecting region by a predetermined distance,
in that the said chosen implantation is carried out on the structure thus obtained fitted with the overlapping mask, along an oblique direction with respect to the first face of the substrate.

25. Method according to Claim 24, characterised in that the two regions of the second pair (18, 19) are implanted by carrying out a chosen implantation of dopants substantially perpendicularly to the first face of the substrate, on the structure fitted with the overlapping mask fixed to the gate.

26. Method according to Claim 24 or 25, characterised in that in step d), in a first implantation area, situated on either side of the edges of the overlapping mask, and in the vicinity of the said first end area (9) of the projecting region (3), a first chosen implantation of dopants is carried out suitable for overdoping (P⁺) the said first implantation area with respect to the substrate,
in that the overlapping mask is removed and, in a second implantation area extending the first as far as the two sides of the projecting region, a second implantation of the same type as the first is carried out, which makes it possible to obtain the two regions (12, 13) of the first pair with a non-uniform doping (P⁺, P⁺⁺).
